# EUROPÄISCHE PATENTSCHRIFT

(11) **EP 1 390 767 B1**
(45) Veröffentlichungstag und Bekanntmachung des Hinweises auf die Patenterteilung: **20.08.2008**
(21) Anmeldenummer: 02771682.8
(22) Anmeldetag: 24.04.2002
(51) Int. Cl.: G01R 11/16, G06M 1/06

(54) **UNIDIREKTIONALES ZÄHLWERK**
UNIDIRECTIONAL COUNTER
COMPTEUR UNIDIRECTIONNEL

(30) Priorität: 21.05.2001 DE 10124972
(43) Veröffentlichungstag der Anmeldung: 25.02.2004
(73) Patentinhaber: Landis+Gyr AG, 6300 Zug (CH)
(72) Erfinder: NIEDERMANN, Thomas, 93051 Regensburg (DE)
(74) Vertreter: Lagler, Louis
(86) Internationale Anmeldenummer: PCT/IB2002/001383
(87) Internationale Veröffentlichungsnummer: WO 2002/095425

(56) Entgegenhaltungen:
- GB-A- 2 054 223
- US-A- 3 195 814
- US-A- 5 609 074

## Beschreibung

Die Erfindung ist dem Gebiet der Zählertechnik zuzuordnen. Sie betrifft ein unidirektionales Zählwerk, das bei potentiellem bidirektionalem Drehrichtungsantrieb eine Anzeige mit unidirektionaler Drehrichtung aufweist.

### STAND DER TECHNIK

Unidirektionale Zählwerke sind so ausgeführt, dass sie den Bezug bzw. Verbrauch beispielsweise von Wasser, Gas oder elektrischer Energie totalisieren und anzeigen. Besonders vorteilhaft ist die Verwendung derartiger unidirektionaler Zählwerke in Elektrizitätszählern und dort im speziellen in Ferraris-Zählern. Im folgenden fokussiert die vorliegende Erfindung die Verwendung unidirektionaler Zählwerke in Ferraris-Zählern ohne die Anwendung dieser Zählwerke auf anderen Gebieten, wie beispielsweise der Gaswirtschaft oder der Wasserwirtschaft auszuschliessen. Unidirektionale Zählwerke Sind in US 5609074 und in GB2054223 offenbaut.

In an sich bekannten Ferraris-Zählern wird aufgrund einer elektrischen Netzspannung und eines elektrischen Verbrauchsstroms eine Rotorscheibenanordnung angetrieben, die dann ein Zählwerk antreibt. Derartige Zählwerke können bekannte Zahlenrollen oder Zahlenscheiben umfassen oder Zeiger aufweisen, die sich vor feststehenden Zifferblättern drehen. Dreht sich die Rotorscheibenanordnung und damit auch der Antrieb des Zählwerks fälschlicherweise entgegengesetzt zur ordentlichen Drehrichtung, so wird durch konventionelle unidirektionale Zählwerke zwischen der Rotorscheibenanordnung und der Anzeige diese falsche Drehrichtung transformiert in die zur steten Aufsummierung korrekte Drehrichtung für diese Anzeige.

Für eine derartige Transformation einer bidirektionalen Drehrichtung einer Rotorscheibenanordnung in eine unidirektionale Drehrichtung für eine Zahlenrollenanordnung beispielsweise, werden bekanntermassen Klinkensysteme eingesetzt, wie sie beispielhaft in der US 4,352,979 gezeigt sind. In dieser Druckschrift ist ein unidirektionales Zählwerk beschrieben, bei dem eine Klinkenanordnung über einen Zahnradantrieb gedreht wird. Je nach Drehrichtung der Klinkenanordnung wird entweder ein erstes oder zweites, Rastzähne aufweisendes Zwischenzahnrad angetrieben, wobei dieses erste bzw. zweite Zwischenzahnrad dann über weitere Zahnräder für den korrekten, aufsummierenden Drehrichtungsantrieb der Anzeige besorgt ist.

Als nachteilig an einer derartigen Anordnung des Standes der Technik kann zum einen die Anzahl der unterschiedlichen Bauteile für das Zählwerk angesehen werden. Darüber hinaus bedingt dieses Zählwerk eine zweiseitige Montage zwischen einer Frontwand und einer parallel zu ihr angeordneten Rückwand einer Gehäuseanordnung, da auf allein einer einzigen, drehenden Achse vier in gleicher oder entgegengesetzter Richtung rotierende Bauteile nebeneinander angeordnet sind, nämlich das Antriebszahnrad, die Klinkenanordnung und das erste bzw. zweite Rastzähne aufweisende Zwischenrad. Eine einseitige Achsmontage ist wegen eines entsprechend grossen statischen Drehmomenteinflusses auf diese Achse undenkbar.

Darüber hinaus wirkt auf das Zählwerk selbst ohne äusseren Antrieb auch dann ein statisches Drehmoment, wenn die Klinkenanordnung aus ihrem labilen oder stabilen Gleichgewicht herausgedreht wird. In Positionen eines Uhrzeigers beschrieben heisst das, dass immer dann auch ein statisches Drehmoment ohne äusseren Antrieb auftritt, sobald die Klinkenanordnung die 12 Uhr- bzw. 6 Uhr-Position verlässt. Diese demzufolge nicht ausbalancierte Klinkenanordnung kann somit bei einer - wohlgemerkt unzulässigen - periodisch wechselnden Drehrichtungsumkehr einen gewissen Einfluss auf die Umschaltgeschwindigkeit nehmen, so dass eine spürbar fehlerhafte Anzeige des Verbrauchs möglich wäre.

Des weiteren weicht bei gleicher Antriebsleistung an einer Rotorscheibenanordnung eines Ferraris-Zählers, d.h. bei gleichem momentanem Verbrauch des zu erfassenden Verbrauchsmediums, die Drehzahl zwischen korrektem Vorwärtslauf und manipuliertem Rückwärtslauf bekanntermassen spürbar voneinander ab. Dies liegt darin begründet, dass derartige Rotorscheibenanordnungen für den korrekten Vorwärtslauf ausgelegt und optimiert sind. In der Regel ist deshalb bei gleicher Antriebsleistung an einer Rotorscheibenanordnung gegenüber dem korrekten Vorwärtslauf eine geringere Drehzahl im manipulierten Rückwärtslauf festzustellen.

### DARSTELLUNG DER ERFINDUNG

Es ist deshalb Aufgabe der Erfindung ein unidirektionales Zählwerk der oben genannten Art weiter zu entwickeln, das vergleichsweise gegenüber dem aufgezeigten Stand der Technik nicht nur bei korrektem Vorwärtslauf sondern auch bei manipuliertem Rückwärtslauf eine genaue Erfassung und ein korrektes Totalisieren von Verbrauchsgütern gewährleistet. Von grosser Bedeutung ist dabei auch, dass eine quasi sofortige Erfassung einer betrugsmässig manipulierten Drehrichtungsumkehr ermöglicht wird.

Darüber hinaus ist es Aufgabe der Erfindung, mit einer vergleichsweise geringeren Anzahl unterschiedlicher Bauteile und mit geringerem Montageaufwand ein ausbalanciertes, von statischen Drehmomenten freies und damit genaueres Zählwerk bereitzustellen. Neben der bekannten zweiseitigen Montage zwischen einer Frontwand und einer parallel zu dieser Frontwand angeordneten Rückwand einer Gehäuseanordnung, soll dieses Zählwerk bevorzugt lediglich einseitig montierbar sein, das heisst, dass es entweder an der Frontwand oder an der Rückwand montierbar sein soll. Des weiteren soll das erfindungsgemässe Zählwerk vergleichsweise kompakter sein und elektromagnetisch bedingte Drehzahlabweichungen einer antreibenden Rotorscheibenanordnung bei erfolgter Drehrichtungsumkehr kompensieren können.

Die Aufgabe der Erfindung wird gelöst durch die Merkmale des Anspruchs 1. Weitere vorteilhafte Ausgestaltungen der Erfindung sind Gegenstand der Unteransprüche.

Der Kern der Erfindung ist darin zu sehen, dass bei einem unidirektionalen Zählwerk zwei über ein Schneckenrad und eine Zahlenanzeige bzw. ein Zwischenrad in Verbindung stehende Rastzähne-Klinken-Systeme in einem Zählwerk nebeneinander angeordnet sind, wobei sich die beiden Rastzähne-Klinken-Systeme dadurch unterscheiden, dass sie für sich betrachtet lediglich in einer Drehrichtung - also entweder bei Rechtslauf oder Linkslauf bzw. Vorwärtslauf oder Rückwärtslauf - quasi spontan wirksam zum Eingriff gelangen. Wesentlich dabei ist, dass sich das Übersetzungsverhältnis zwischen den Rastzähne-Klinken-Systemen und der Zahlenanzeige bzw. dem Zwischenrad für den Vorwärtslauf und den Rückwärtslauf unterscheiden. Somit wird ein Drehzahlfehler bei manipuliertem Rückwärtslauf in dem unidirektionalen Zählwerk kompensiert, der ursächlich von einer für den Vorwärtslauf ausgelegten und optimierten Rotorscheibenanordnung herrührt. Bei gleichem zu erfassendem Verbrauch zeigt auf diese Weise das unidirektionale Zählwerk sowohl bei Vorwärtslauf als auch bei Rückwärtslauf eine nahezu identische Anzahl Verbrauchseinheiten pro Zeiteinheit an, so dass die Verbrauchsanzeige gleichermassen völlig unabhängig von der Drehrichtung einer an sich für den Vorwärtslauf ausgelegten und optimierten Rotorscheibenanordnung normgerecht genau totalisiert und darstellt. Kurz gesagt kompensiert das erfindungsgemässe unidirektionale Zählwerk bei manipuliertem Drehrichtungswechsel der Rotorscheibenanordnung den Drehzahlfehler derselben, der in ihrer elektromagnetisch optimierten Auslegung begründet liegt.

Besonders vorteilhaft ist, dass diese erfindungsgemässe Drehzahlkompensation durch einfache Ausgestaltung von Zähnezahlverhältnissen im unidirektionalen Zählwerk realisierbar ist. Da die beiden Rastzähne-Klinken-Systeme zwischen einem Schneckenrad und einem Umkehrrad unmittelbar in Wirkverbindung zueinander stehen, ist hier eine geeignete Kompensation durch die Wahl eines entsprechenden Zähnezahlverhältnisses grösser oder kleiner 1 einfach einstellbar. Darüber hinaus stehen die Rastzähne-Klinken-Systeme über ein erstes und ein zweites Systemrad zueinander in Wirkverbindung, so dass auch hier eine einfache Anpassung des Übersetzungsverhältnisses mittels Wahl eines geeigneten Zähnezahlverhältnisses grösser oder kleiner als 1 gegeben ist. Des weiteren ist eine Anpassung mittels Kombination beider Einstellmöglichkeiten zwischen Schneckenrad und Umkehrrad bzw. den beiden Systemrädern für eine geeignete Übersetzung erfindungsgemäss denkbar. Diese kombinierte Anpassungsvariante ist wegen der feinen Einstellmöglichkeit der Übersetzungsverhältnisse von besonderem Vorteil.

Zudem ermöglicht das erfindungsgemässe Zählwerk im Zusammenspiel zwischen einem Klinkenpaar und den zugehörigen Rastzähnen eines Rastzähne-Klinken-Systems eine vergleichsweise zum Stand der Technik wesentlich schnellere Umschaltung bei fälschlicherweisem Drehrichtungswechsel einer Antriebseinheit, wie beispielsweise eine Rotorscheibenanordnung eines Ferraris-Zählers. Selbst unzulässig manipulierte, periodische Drehrichtungsumschaltungen führen somit zu einem quasi direkten Umschalten von dem einen sich im Eingriff befindenden Rastzähne-Klinken-System zu dem weiteren Rastzähne-Klinken-System, so dass die Zählwerkanzeige nahezu unterbruchsfrei weiter unidirektional aufsummierend angetrieben wird.

Unter dem Ausdruck "Rastzähne-Klinken-System" ist dabei eine Anordnung zu verstehen, bei der Klinken an einem sich in eine Richtung drehenden Bauteil entweder an Rastzähnen eines weiteren rotierenden Bauteils zum Eingriff gelangen oder aber aufgrund der entgegengesetzten Drehrichtung eben gerade nicht zum Eingriff kommen und damit leer laufen.

Als Schneckenrad ist im obigen Sinn ein Bindeglied des Zählwerks zu einer Antriebsschnecke zu verstehen, wie sie beispielsweise hinreichend in Verbindung mit einer Rotorscheibenanordnung in einem Ferraris-Zähler bekannt ist. Der unmittelbare Antrieb der Zahlenrollen wird durch das so bezeichnete Zwischenrad bewerkstelligt. Dabei ist zu bemerken, dass dieses Zwischenrad keinesfalls einen erfindungswesentlichen Charakter geniesst. Ein Fachmann auf dem Gebiet der Zählwerktechnik ist selbstverständlich auch ohne erfinderisches Dazutun in der Lage dieses Zwischenrad zu eliminieren.

Erfindungswesentlich ist, dass sich bei beiden Rastzähne-Klinken-Systemen mindestens jeweils eine Klinke in Eingriffsposition in Richtung zu einem Rastzahn oder im direkten Eingriff mit einem Rastzahn befindet. Der entscheidende Vorteil, der dabei zum Tragen kommt, ist in der quasi spontanen Eingriffsmöglichkeit des zu diesem Zeitpunkt sich nicht im Eingriff befindlichen Rastzähne-Klinken-Systems zu sehen, wenn sich die Drehrichtung der antreibenden Schnecke ändert. Bei demjenigen Rastzähne-Klinken-System, das sich in einem Zeitraum nicht im Eingriff, sondern im Leerlauf befindet, wirken die Klinken zueinander in Verbindung mit den gegenüberliegenden Rastzähnen wie Wippen, die sich gegenseitig in Eingriffsposition zu diesen Rastzähnen stossen, sodass mindestens eine dieser beiden Klinken sich immer in dieser Eingriffsposition befindet.

Besonders vorteilhaft erweist es sich, wenn die beiden Klinkenpaare an den beiden Systemrädern in Phasenopposition zueinander angeordnet sind und sich demzufolge gegenphasig drehen. Das bedeutet, dass das erste Klinkenpaar des ersten Systemrads sich dann in 12-Uhr-Stellung befindet, wenn das zweite Klinkenpaar des zweiten Systemrads sich gerade in 6-Uhr-Position befindet. Wenn dann beide Systemräder - die über das Zwischenrad miteinander gekoppelt sind - sich drehen, kompensieren sich die auf dieses Zwischenrad wirkenden Drehmomente der beiden Systemräder mit den Klinken vollständig aus. Diese ausbalancierte Anordnung ist somit in jeder Stellung frei von solchen Drehmomenten, die ausschliesslich auf die Anordnung an sich zurückzuführen sind und somit bei Stillstand des Zählwerks, das heisst auch statisch wirken.

Das erfindungsgemässe Zählwerk birgt den weiteren Vorteil einer sehr kompakten Anordnung, da das Schneckenrad und das erste Systemrad bzw. das Umkehrrad und das zweite Systemrad koaxial zueinander jeweils auf einer Achse montiert sind. Hierdurch entstehen selbst bei einer einseitigen Montage der Achsen lediglich verschwindend geringe Biegemomente zwischen diesen Achsen. Eine derartige Montage ist zudem einfach und preiswert durchführbar.

Des weiteren werden im Vergleich zum aufgezeigten Stand der Technik weniger unterschiedliche Bauteile für das Zählwerk verwendet, was sich auch kostengünstig auswirkt.

### KURZE BESCHREIBUNG DER ZEICHNUNG

In der Zeichnung sind Ausführungsbeispiele schematisch und vereinfacht dargestellt. Die Drehrichtungen der dargestellten Zahnräder sind mittels Pfeilen angezeigt.
Es zeigen:
- Fig. 1: eine abgewickelte Darstellung eines erfindungsgemässen Zählwerks mit einer Zahlenrolle als Anzeige und antreibender Schnecke;
- Fig. 2: eine Schnittdarstellung durch das Zählwerk entlang der Schnittlinie B-B' in der Fig. 1, und
- Fig. 3a, b, c: weitere Schnittdarstellungen durch das Zählwerk entlang der Linie B-B' in der Fig. 1.

### WEGE ZUR AUSFÜHRUNG DER ERFINDUNG

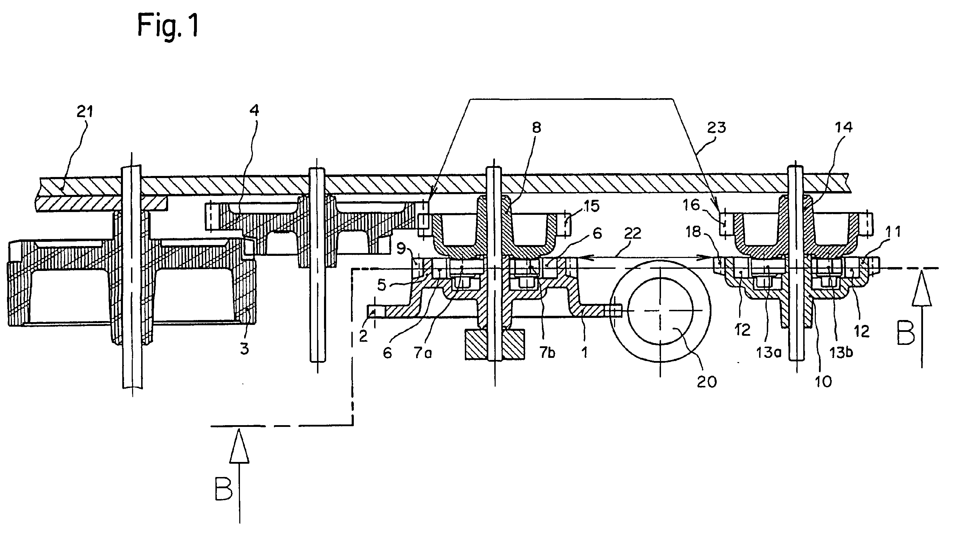

Fig. 1 zeigt ein unidirektionales Zählwerk in einer geschnittenen, abgewickelten Darstellung. Unter abgewickelter Darstellung ist zu verstehen, dass alle Zählwerkachsen in einer Ebenen gezeichnet sind, obwohl sie tatsächlich nicht in einer solchen angeordnet sind. Um dennoch klar zu machen, welche Zahnräder des Zählwerks unmittelbar ineinander kämmen, das heisst einander antreiben, sind zwei Wirkverbindungspfeile 22 und 23 eingezeichnet.

Bei dem in Fig. 1 gezeigten Zählwerk handelt es sich um ein Rollenzählwerk, wobei der Einfachheit halber lediglich eine einzige Zahlenrolle 3 als Anzeige symbolisch für eine Vielzahl von nebeneinander koaxial angeordneten Zahlenrollen eingezeichnet ist. Das Zählwerk eignet sich grundsätzlich zum Totalisieren und Anzeigen bei Bezug oder Lieferung von Energieeinheiten in der Elektrizitätswirtschaft, der Gas- oder Wasserwirtschaft. Im folgenden wird allerdings der Schwerpunkt auf das Totalisieren und Anzeigen von elektrischer Energie gelegt, und dabei im besonderen der Bezug derartiger Energieeinheiten beleuchtet. Keinesfalls sollte die Erfindung auf die gezeigte und beschriebene Ausführungsform reduziert werden, da jede andere Verwendung des Zählwerks denkbar ist, ohne den der Erfindung zugrundeliegenden Kern zu verlassen. Unter diese Prämisse fällt auch die Darstellungsart mittels Zahlenrollen; ohne den Erfindungsgedanken zu verlassen sind nämlich ebenfalls statt Zahlenrollen Zahlenscheiben oder Zeiger vor einem Zifferblatt als Anzeige denkbar.

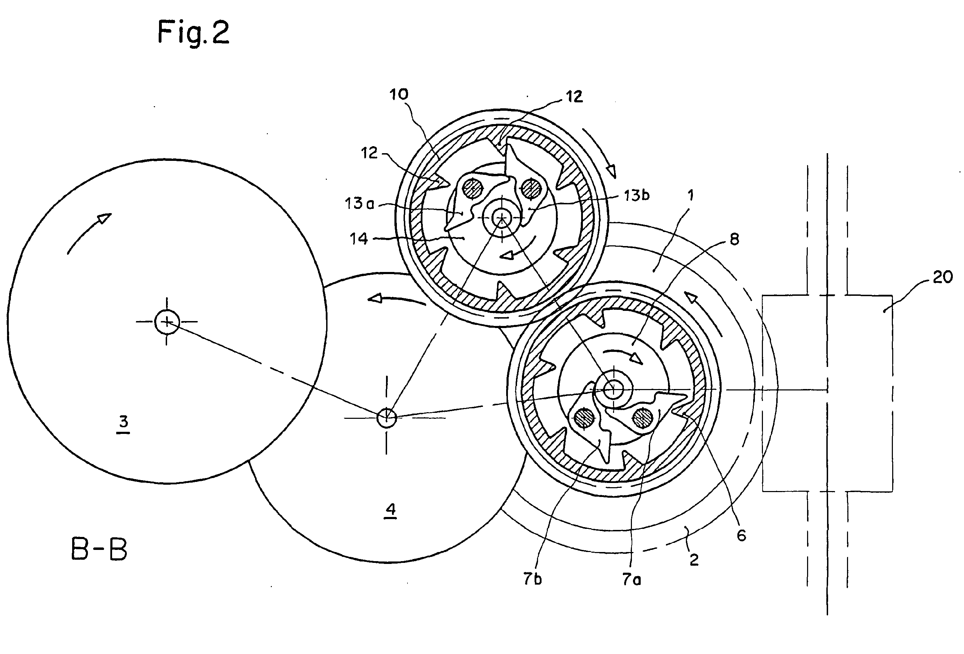

Das erfindungsgemässe Zählwerk wird über eine Antriebsschnecke 20 angetrieben, die koaxial mit einer bekannten, hier nicht dargestellten, Rotorscheibenanordnung verbunden ist. Die Fig. 2 verdeutlicht in Verbindung mit Fig. 1 die Anordnung der Antriebsschnecke 20 mit dem Zählwerk. Hierfür ist in Fig. 2 eine Schnittdarstellung entlang der Schnittlinie B-B' in Fig. 1 gezeigt. Die Antriebsschnecke 20 treibt ein Schneckenrad 1 im Gegenuhrzeigersinn an einer ersten Stirnradverzahnung 2 an. Dieses Schneckenrad 1 weist koaxial zu der ersten Stirnradverzahnung 2 einen Zylinderansatz 5 auf. Die Innenseite des Zylinderansatzes 5 ist mit einer Anzahl Rastzähnen 6 versehen, während die Aussenseite des Zylinderansatzes 5 eine weitere, zweite Stimradverzahnung 9 des Schneckenrades 1 trägt.

Über diese zweite Stirnradverzahnung 9 wird ein Umkehrrad 10 im Uhrzeigersinn gedreht, wobei der Antrieb über eine Stirnradverzahnung 18 des Umkehrrads 10 erfolgt. Diese Stirnradverzahnung 18 ist auf der Aussenseite eines Zylinderansatzes 11 des Umkehrrads 10 angeordnet, wobei sich auf der Innenseite dieses Zylinderansatzes 11 Rastzähne 12 befinden. Einer dieser Rastzähne 12 ist im Eingriff mit einer Klinke 13b, die auf einem Systemrad 14 schwenkbar gelagert ist. Eine weitere Klinke 13a ist ebenfalls schwenkbar an dem Systemrad 14 befestigt, wobei beide Klinken 13a und 13b in Wirkverbindung zueinander angeordnet sind.

Dadurch, dass sich die eine Klinke 13b mit einem Rastzahn 12 im Eingriff befindet, dreht sich das Systemrad 14 ebenfalls in Uhrzeigersinn. Über eine Stimradverzahnung 16 an dem Systemrad 14 ist ein Zwischenrad 4 verbunden, das wiederum direkt eine Zahlenrolle 3 antreibt. Das Zwischenrad 4 wird dabei in Gegenuhrzeigersinn und die Zahlenrolle 3 in Uhrzeigersinn angetrieben.

Solange das Schneckenrad 1 im Gegenuhrzeigersinn dreht, streifen die Rastzähne 6 auf der Innenseite des Zylinderansatzes 5 an einem Klinkenpaar 7a, 7b eines weiteren Systemrads 8 vorbei, und zwar dergestalt, dass diese gegenseitig in Wirkverbindung zueinander angeordneten Klinken 7a, 7b jeweils in Verbindung mit den Rastzähne 6 des Schneckenrads 1 abwechselnd in Eingriffsposition zu einem dieser Rastzähne 6 geschwenkt werden. Das weitere Systemrad 8 ist über eine an ihm angeordnete Stirnradverzahnung 15 mit dem in Gegenuhrzeigersinn drehenden Zwischenrad 4 verbunden und dreht demzufolge in Uhrzeigersinn.

Das Rastzähne-Klinken-System 6, 7a, 7b zwischen dem Schneckenrad 1 und dem Systemrad 8 befindet sich bei der Drehung des Schneckenrads 1 in Gegenuhrzeigersinn in potentieller Eingriffsposition, so dass bei einer Drehrichtungsumkehr des Schneckenrads 1 in Richtung Uhrzeigersinn (nicht dargestellt) ein sofortiger Eingriff mindestens einer Klinke 7a, 7b mit einem Rastzahn 6 erfolgen kann. In diesem Fall würden das Schneckenrad 1 und das Systemrad 8 in Uhrzeigersinn drehen. Demzufolge würde das Zwischenrad 4 wiederum im Gegenuhrzeigersinn und die Zahlenrolle 3 in Uhrzeigersinn drehen. Zu diesem Zeitpunkt dreht dann das Umkehrrad 10 im Gegenuhrzeigersinn, so dass die Klinken 13a, 13b des Systemrads 8 durch die Rastzähne 12 lediglich gestreift und abwechselnd in Eingriffsposition geschwenkt werden.

Erfindungswesentlich ist, dass lediglich eines der beiden Rastzähne-Klinken-Systeme 6, 7a, 7b, 12, 13a, 13b sich im Eingriff befindet während das andere sich permanent in potentieller Eingriffsposition befindet. Diese Anordnung von zwei Rastzähne-Klinken-Systemen 6, 7a, 7b, 12, 13a, 13b in einem Zählwerk ermöglicht auf einfache Weise bei jedem Drehrichtungswechsel des Schneckenrads 1 eine quasi spontane Umschaltung, sodass ein hochpräzises Totalisieren und Anzeigen eines Energieverbrauchs bereitstellt wird.

Die Erfindung zeichnet sich dadurch aus, dass auf einfachste Weise bei Drehrichtungsumkehr und verbleibendem, konstantem Verbrauchsbetrag die Drehzahl des Zählwerks beim Wechsel vom Vorwärtsbetrieb zum Rückwärtsbetrieb unterschiedlich ist. Die Erfahrung lehrt nämlich, dass Rotorscheibenanordnungen grundsätzlich in einer Drehrichtung bei korrektem Betrieb eine eingestellte, geeichte Drehzahl aufweisen, hingegen können sie bei manipulierter Drehrichtungsumkehr und konstant verbleibendem Verbrauchsbetrag eine vom korrekten Betriebsfall abweichende Drehzahl aufweisen. Regelmässig ist bei Rückwärtsbetrieb die Drehzahl der Rotorscheibenanordnung vergleichsweise langsamer gegenüber dem Vorwärtsbetrieb. Die Erfindung sieht vor, diesen "Drehzahlfehler" mittels einfacher Anpassungen von Zähnezahlverhältnissen in dem unidirektionalen Zählwerk zu kompensieren.

Erfindungsgemäss kann diesem Problem sehr einfach begegnet werden, indem das Zähnezahlverhältnis vorwärtslaufender zu rückwärtslaufender Zahnräder entsprechend anpassbar ist, was allerdings in den Figuren der Einfachheit halber nicht explizit dargestellt ist. Hierfür eignet sich zum einen die Einstellung des Zähnezahlverhältnisses zwischen der Stirnradverzahnung 9 des Schneckenrads 1 und der hierdurch antreibbaren Stirnradverzahnung 18 des Umkehrrads 10 von dem Verhältnis Eins zu dem Verhältnis ungleich Eins, und/oder zum anderen die Einstellung des Zähnezahlverhältnisses zwischen der Stirnradverzahnung 15 des ersten Systemrads 8 und einer Stimradverzahnung 16 des zweiten Systemrads 14 von dem Verhältnis Eins zu dem Verhältnis ungleich Eins. Wählt man beispielsweise eine Zähnezahl von 41 am Schneckenrad 1 und 40 am Umkehrrad 10, so ergibt sich eine Übersetzung von 1.025:1. Dies bedeutet, das bei manipulierter Rückwärtsdrehung eine um 2.5% grössere Zählwerkanzeige ergibt als bei korrekter Vorwärtsdrehung. Diese erhöhte Drehzahl des Zählwerks kompensiert somit auf einfache Weise die vergleichsweise langsamere, Drehzahl einer Rotorscheibenanordnung in Rückwärtsrichtung. Mittels dieser erfindungswesentlichen Anpassung der Zähnezahlverhältnisse zwischen dem Scheckenrad 1 und dem Umkehrrad 10 bzw. zwischen dem ersten und zweiten Systemrad 8, 14 ist jede Drehzahlanpassung einstellbar, wobei die Zähnezahlverhältnisse lediglich einer fachmännischen Ausgestaltung bedarf.

Sollte beispielsweise eine Rotorscheibenanordnung bei unkorrektem Drehsinn schneller drehen als bei korrektem, so ist eine entsprechende Anpassung der Zähnezahlverhältnisse im Sinne der Erfindung ebenfalls denkbar, denn auf einfache Art kann eines der oben beschriebenen Zähnezahlverhältnisse auch auf ein Verhältnis kleiner als Eins eingestellt werden. Selbstverständlich ist auch denkbar die Anzahl der in Wirkverbindung zueinander stehenden Klinken pro Rastzähne-Klinken-System auf drei oder mehr Klinken zu erhöhen, womit die Anzahl Eingriffsmöglichkeiten zu den Rastzähnen erhöht wird. Hieraus ergibt sich in konsequenter Weise im Sinne der Erfindung eine Verfeinerung der Eingriffsmöglichkeiten bei unkorrektem Drehrichtungswechsel.

Darüber hinaus ist das Zählwerk aus einer vergleichsweise zum Stand der Technik kleinen Anzahl unterschiedlicher Bauteile aufgebaut, was eine preiswerte Herstellung und Montage ermöglicht. Vereinfachend kommt hinzu, dass das gesamte Zählwerk an lediglich einer einzigen Seite einer Gehäusewand für dieses Zählwerk installiert ist, was die Montage erleichtert und schnell durchführbar macht.

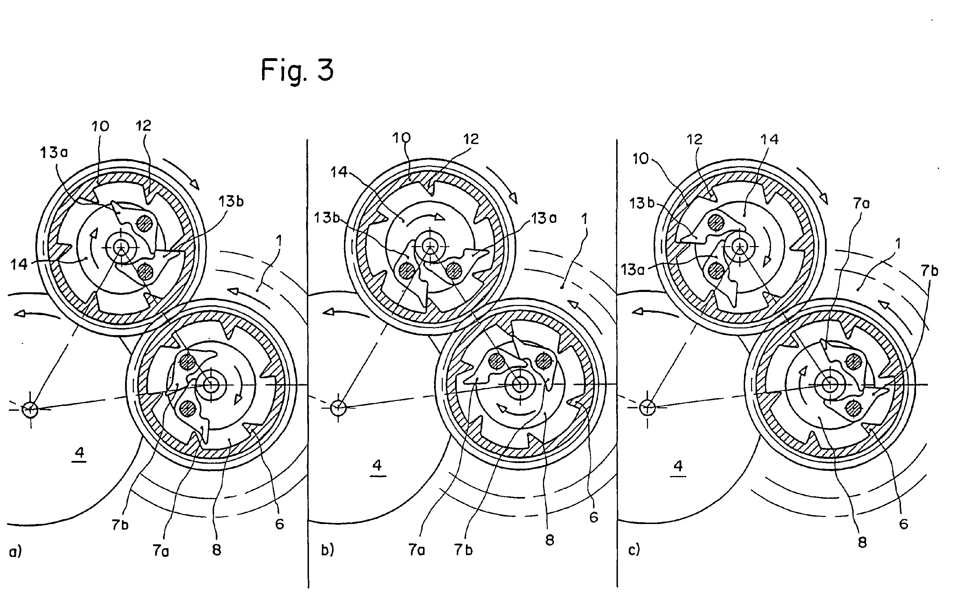

In Zusammenschau der Fig. 2 und Fig. 3 wird eine vollständige Umdrehung des Schneckenrads 1 in korrekter Drehrichtung im Gegenuhrzeigersinn gezeigt. Startend mit Fig. 2 befindet sich das erste Rastzähne-Klinken-System 6, 7a, 7b zwischen dem Schneckenrad 1 und dem ersten Systemrad 8 in 6-Uhr-Position und das zweite Rastzähne-Klinken-System 12, 13a, 13b zwischen dem Umkehrrad 10 und dem zweiten Systemrad 14 in 12-Uhr-Position. Wird nun das Schneckenrad in korrekter Drehrichtung im Gegenuhrzeigersinn gedreht, so verlagert sich das erste Rastzähne-Klinken-System 6, 7a, 7b in 9-Uhr-Position, während das zweite Rastzähne-Klinken-System 12, 13a, 13b in 3-Uhr-Position geht, wie Fig. 3a erhellt. Dabei wird deutlich, dass die eine voreilende Klinke 7a durch die benachbarte, nacheilende Klinke 7b in Folge Vorbeistreifens eines Rastzahns 6 in Eingriffsposition geschwenkt wird und unmittelbar anschliessend die voreilende Klinke 7a in Folge Vorbeistreifens eines anderen Rastzahns 6 die nacheilende Klinke 7b in Eingriffsposition geschwenkt würde, was hier allerdings vereinfachend nicht dargestellt ist.

Die Fig. 3b und die Fig. 3c zeigen quasi selbsterläutemd, wie das erste Rastzähne-Klinken-System 6, 7a, 7b über die 12-Uhr-Position in die 3-Uhr-Position, bzw. wie das zweite Rastzähne-Klinken-System 12, 13a, 13b über die 6-Uhr-Position in die 9-Uhr-Position gedreht wird. Besonders hervorzuheben ist bei Betrachtung der Abfolge der Darstellungen in den Fig. 2 und Fig. 3, dass das erste Rastzähne-Klinken-System 6, 7a, 7b in Bezug auf das zweite Rastzähne-Klinken-System 12, 13a, 13b gegenphasig angeordnet ist. Das heisst, dass die beiden Rastzähne-Klinken-Systeme 6, 7a, 7b, 12, 13a, 13b in Phasenopposition zueinander alle Stellungen einer Umdrehung durchlaufen. Der entscheidende Vorteil ist dabei, dass auf das die beiden Rastzähne-Klinken-Systeme 6, 7a, 7b, 12, 13a, 13b verbindende Zwischenrad kein statisches, also allein auf der geometrischen Anordnung basierendes Drehmoment wirkt.

### BEZUGSZEICHEN

- 1: Schneckenrad
- 2: erste Stirnradverzahnung an 1
- 3: Zahlenrolle
- 4: Zwischenrad
- 5: Zylinderansatz an 1
- 6: Rastzähne an 1
- 7a,b: Klinkenpaar an 8
- 8: Systemrad
- 9: zweite Stirnradverzahnung an 1
- 10: Umkehrrad
- 11: Zylinderansatz an 10
- 12: Rastzähne an 10
- 13a,b: Klinkenpaar an 14
- 14: System rad
- 15: Stirnradverzahnung an 8
- 16: Stimradverzahnung an 14
- 17: Innenseite von 5
- 18: Stirnradverzahnung an 10
- 20: Antriebsschnecke
- 21: Gehäusewand
- 22: Wirkverbindung
- 23: Wirkverbindung

## Patentansprüche

1. Unidirektionales Zählwerk mit einem antreibbaren Schneckenrad (1) und mindestens einer durch die Drehung des Schneckenrads (1) antreibbaren Zahlenanzeige (3), wobei das Schneckenrad (1) über ein erstes Rastzähne-Klinken-System (6, 7a, b) zu einem ersten Systemrad (8) in Wirkverbindung steht, und dieses erste Systemrad (8) in Wirkverbindung zu der Zahlenanzeige (3) steht,
**dadurch gekennzeichnet,**
- **dass** mit dem Schneckenrad (1) ein Umkehrrad (10) antreibbar ist, wobei dieses Umkehrrad (10) über ein zweites Rastzähne-Klinken-System (12, 13a, b) zu einem zweiten Systemrad (14) in Wirkverbindung steht, und dieses zweite Systemrad (14) ebenfalls in Wirkverbindung zu der Zahlenanzeige (3) steht,
- **dass** sich in Abhängigkeit der Drehrichtung des Schneckenrads (1) entweder das erste Rastzähne-Klinken-System (6, 7a, b) oder das zweite Rastzähne-Klinken-System (12, 13a, b) im Eingriff befindet,
- **dass** das Schneckenrad (1) und das Umkehrrad (10) mittels Stirnradverzahnungen (9, 18) bei einem Übersetzungsverhältnis dieser Stirnradverzahnungen (9, 18) ungleich 1 ineinander kämmen, und/oder
- **dass** ein Zähnezahlverhältnis zwischen einer Stirnradverzahnung (15) des ersten Systemrads (8) und einer Stimradverzahnung (16) des zweiten Systemrads (14) ungleich 1 ist.

2. Unidirektionales Zählwerk nach Anspruch 1, **dadurch gekennzeichnet, dass** das erste Rastzähne-Klinken-System (6, 7a, b) mindestens ein erstes Klinkenpaar (7a, b) mit zwei zueinander in Wirkverbindung stehenden, gleichwirkenden Klinken (7a, b) umfasst.

3. Unidirektionales Zählwerk nach Anspruch 2, **dadurch gekennzeichnet, dass** das zweite Rastzähne-Klinken-System (12, 13a, b) mindestens ein zweites Klinkenpaar (13a, b) mit zwei zueinander in Wirkverbindung stehenden, gleichwirkenden Klinken (13a, b) umfasst, und
- dass mindestens jeweils eine Klinke (7a, b, 13a, b) des ersten und zweiten Rastzähne-Klinken-Systems (6, 7a, b; 12, 13a, b) sich in Eingriffsposition in Richtung zu einem Rastzahn (6, 12) bzw. im direkten Eingriff mit einem Rastzahn (6, 12) befindet.

4. Unidirektionales Zählwerk nach einem der vorstehenden Ansprüche 1 bis 3, **dadurch gekennzeichnet, dass** eine Anzahl Rastzähne (6) an einem ersten Zylinderansatz (5) des Schneckenrads (1) angeordnet ist, und dass das mindestens eine erste Klinkenpaar (7a,b) an dem ersten Systemrad (8) angeordnet ist.

5. Unidirektionales Zählwerk nach einem der vorstehenden Ansprüche 1 bis 4, **dadurch gekennzeichnet, dass** eine Anzahl Rastzähne (12) an einem zweiten Zylinderansatz (11) des Umkehrrads (10) angeordnet ist, und dass das mindestens eine zweite Klinkenpaar (12a,b) an dem zweiten Systemrad (14) angeordnet ist.

6. Unidirektionales Zählwerk nach einem der vorstehenden Ansprüche 1 bis 5, **dadurch gekennzeichnet, dass** das erste Systemrad (8) und das zweite Systemrad (14) über ein Zwischenrad (4) verbunden sind, wobei das erste Klinkenpaar (7a,b) zum zweiten Klinkenpaar (12a,b) in Phasenopposition angeordnet ist.

7. Unidirektionales Zählwerk nach einem der vorstehenden Ansprüche 4 bis 6, **dadurch gekennzeichnet, dass** am Schneckenrad (1) die Anzahl Rastzähne (6) auf einer Innenseite (17) des ersten Zylinderansatzes (5) angeordnet ist.

8. Unidirektionales Zählwerk nach einem der vorstehenden Ansprüche 5 bis 7, **dadurch gekennzeichnet, dass** die Anzahl Rastzähne (12) des Umlenkrads (10) auf einer Innenseite (19) des zweiten Zylinderansatzes (11) angeordnet ist.

9. Unidirektionales Zählwerk nach einem der vorstehenden Ansprüche 1 bis 8, **dadurch gekennzeichnet, dass** das Schneckenrad (1) und das erste Systemrad (8) koaxial angeordnet sind.

10. Unidirektionales Zählwerk nach einem der vorstehenden Ansprüche 1 bis 9, **dadurch gekennzeichnet, dass** das Umkehrrad (10) und das zweite Systemrad (14) koaxial angeordnet sind.

11. Unidirektionales Zählwerk nach einem der vorstehenden Ansprüche 1 bis 10, **dadurch gekennzeichnet, dass** das Schneckenrad (1) und das Umkehrrad (10) parallel zueinander angeordnet sind.

## Claims

1. A unidirectional counter having a drivable worm wheel (1) and at least one numbered display (3), which is drivable by the rotation of the worm wheel (1), the worm wheel (1) being operatively connected via a first ratchet-pawl system (6, 7a,b) to a first system wheel (8), and this first system wheel (8) being operatively connected to the numbered display (3), **characterized in that**
- an inversion wheel (10) is drivable by the worm wheel (1), this inversion wheel (10) being operatively connected via a second ratchet-pawl system (12, 13a,b) to a second system wheel (14), and this second system wheel (14) also being operatively connected to the numbered display (3),
- as a function of the rotational direction of the worm wheel (1), either the first ratchet-pawl system (6, 7a, b) or the second ratchet-pawl system (12, 13a, b) is engaged,
- using spur teeth (9, 18), the worm wheel (1) and the inversion wheel (10) engage in one another at a multiplication ratio of these spur teeth (9, 18) not equal to 1, and/or
- a tooth count ratio between spur teeth (15) of the first system wheel (8) and spur teeth (16) of the second system wheel (14) is not equal to 1.

2. The unidirectional counter according to Claim 1, **characterized in that** the first ratchet-pawl system (6, 7a, b) includes at least one first pawl pair (7a, b) having two identically acting pawls (7a, b), which are operatively connected to one another.

3. The unidirectional counter according to Claim 2, **characterized in that** the second ratchet-pawl system (12, 13a, b) includes at least one second pawl pair (13a, b) having two identically acting pawls (13a, b), which are operatively connected to one another, and at least one pawl (7a, b, 13a, b) at a time of the first and second ratchet-pawl systems (6, 7a, b; 12, 13a, b) is located in the engagement position in the direction toward a ratchet tooth (6, 12) and/or is directly engaged with a ratchet tooth (6, 12).

4. The unidirectional counter according to one of preceding Claims 1 to 3, **characterized in that** a number of ratchet teeth (6) are positioned on a first cylinder projection (5) of the worm wheel (1), and at least one first pawl pair (7a, b) is positioned on the first system wheel (8).

5. The unidirectional counter according to one of preceding Claims 1 to 4, **characterized in that** a number of ratchet teeth (12) are positioned on a second cylinder projection (11) of the inversion wheel (10), and at least the one second pawl pair (13a, b) is positioned on the second system wheel (14).

6. The unidirectional counter according to one of preceding Claims 1 to 5, **characterized in that** the first system wheel (8) and the second system wheel (14) are connected via an intermediate wheel (4), the first pawl pair (7a, b) being positioned in phase opposition to the second pawl pair (13a, b).

7. The unidirectional counter according to one of preceding Claims 4 to 6, **characterized in that**, on the worm wheel (1), the number of ratchet teeth (6) is positioned on the inside (17) of the first cylinder projection (5).

8. The unidirectional counter according to one of preceding Claims 5 to 7, **characterized in that** the number of ratchet teeth (12) of the inversion wheel (10) are positioned on the inside (19) of the second cylinder projection (11).

9. The unidirectional counter according to one of preceding Claims 1 to 8, **characterized in that** the worm wheel (1) and the first system wheel (8) are positioned coaxially.

10. The unidirectional counter according to one of preceding Claims 1 to 9, **characterized in that** the inversion wheel (10) and the second system wheel (14) are positioned coaxially.

11. The unidirectional counter according to one of preceding Claims 1 to 10, **characterized in that** the worm wheel (1) and the inversion wheel (10) are positioned parallel to one another.

## Revendications

1. Compteur unidirectionnel avec une roue hélicoïdale pouvant être entraîné (1) et avec au moins un affichage numérique (3) pouvant être entraîné par la rotation de la roue hélicoïdale (1), la roue hélicoïdale (1) étant en liaison active par le biais d'un premier système d'encliquetage à dents (6, 7a, b) avec une première roue du système (8) et cette première roue du système (8) étant en liaison active avec l'affichage numérique (3),
**caractérisé en ce que**,
- une roue d'inversion (10) peut être entraînée avec la roue hélicoïdale (1), cette roue d'inversion (10) étant en liaison active par le biais d'un deuxième système d'encliquetage à dents (12, 13a, b) avec une deuxième roue du système (14), et cette deuxième roue du système (14) étant également en liaison active avec l'affichage numérique (3),
- le premier système d'encliquetage à dents (6, 7a, b) ou le deuxième système d'encliquetage à dents (12, 13a, b) se trouve en prise en fonction du sens de rotation de la roue hélicoïdale (1),
- la roue hélicoïdale (1) et la roue d'inversion (10) s'engrènent au moyen de dentures droites (9, 18) dans un rapport de transformation de ces dentures droites (9, 18) différent de 1, et/ou
- un rapport d'engrenage entre une denture droite (15) de la première roue du système (8) et une denture droite (16) de la deuxième roue du système (14) est différent de 1.

2. Compteur unidirectionnel selon la revendication 1, **caractérisé en ce que** le premier système d'encliquetage à dents (6, 7a, b) comporte au moins une première paire de cliquets (7a, b) avec deux cliquets (7a, b) à action égale agissant en liaison active l'un par rapport à l'autre.

3. Compteur unidirectionnel selon la revendication 2, **caractérisé en ce que** le deuxième système d'encliquetage à dents (12, 13a, b) comprend au moins une deuxième paire de cliquets (13a, b) avec deux cliquets (13a, b) à action égale, agissant en liaison active l'un par rapport à l'autre, et
- **en ce qu'**au moins respectivement un cliquet (7a, b, 13a, b) du premier et du deuxième système d'encliquetage à dents (6, 7a, b ; 12, 13a, b) se trouve en position d'engrenage dans le sens d'une dent d'encliquetage (6, 12) ou est en prise directe avec une dent d'encliquetage (6, 12).

4. Compteur unidirectionnel selon l'une quelconque des revendications précédentes 1 à 3, **caractérisé en ce qu'**un nombre de dents d'encliquetage (6) est disposé au niveau d'une première embase cylindrique (5) de la roue hélicoïdale (1), et **en ce que** la au moins première paire de cliquets (7a, b) est disposée au niveau de la première roue du système (8).

5. Compteur unidirectionnel selon l'une quelconque des revendications précédentes 1 à 4, **caractérisé en ce qu'**un nombre de dents d'encliquetage (12) est disposé au niveau d'une deuxième embase cylindrique (11) de la roue d'inversion (10), et **en ce que** la au moins deuxième paire de cliquets (12a, b) est disposée au niveau de la deuxième roue du système (14).

6. Compteur unidirectionnel selon l'une quelconque des revendications précédentes 1 à 5, **caractérisé en ce que** la première roue du système (8) et la deuxième roue du système (14) sont reliées par une roue intermédiaire (4), la première paire de cliquets (7a, b) étant disposée en opposition de phases par rapport à la deuxième paire de cliquets (12a, b).

7. Compteur unidirectionnel selon l'une quelconque des revendications précédentes 4 à 6, **caractérisé en ce qu'**au niveau de la roue hélicoïdale (1), le nombre de dents d'encliquetage (6) est disposé sur un côté intérieur (17) de la première embase cylindrique (5).

8. Compteur unidirectionnel selon l'une quelconque des revendications précédentes 5 à 7, **caractérisé en ce que** le nombre de dents d'encliquetage (12) de la roue d'inversion (10) est disposé sur un côté intérieur (19) de la deuxième embase cylindrique (11).

9. Compteur unidirectionnel selon l'une quelconque des revendications précédentes 1 à 8, **caractérisé en ce que** la roue hélicoïdale (1) et la première roue du système (8) sont disposées de manière coaxiale.

10. Compteur unidirectionnel selon l'une quelconque des revendications précédentes 1 à 9, **caractérisé en ce que** la roue d'inversion (10) et la deuxième roue du système (14) sont disposées de manière coaxiale.

11. Compteur unidirectionnel selon l'une quelconque des revendications précédentes 1 à 10, **caractérisé en ce que** la roue hélicoïdale (1) et la roue d'inversion (10) sont disposées de manière parallèle l'une par rapport à l'autre.
